# EUROPÄISCHE PATENTSCHRIFT

(11) **EP 2 999 322 B1**
(45) Veröffentlichungstag und Bekanntmachung des Hinweises auf die Patenterteilung: **23.11.2016**
(21) Anmeldenummer: 15158736.7
(22) Anmeldetag: 12.03.2015
(51) Int. Cl.: H05K 7/20

(54) **Vorrichtung zur Übertragung von Wärme**
Device for transferring heat
Dispositif de transfert de chaleur

(30) Priorität: 19.09.2014 EP 14185527
(43) Veröffentlichungstag der Anmeldung: 23.03.2016
(73) Patentinhaber: Pentair Technical Solutions GmbH, 75334 Straubenhardt (DE)
(72) Erfinder: Joist, Michael, 76571 Gaggenau (DE); Curatolo, Stefan, 76461 Muggensturm (DE)
(74) Vertreter: Durm & Partner

(56) Entgegenhaltungen:
- WO-A1-2013/135595
- US-A1- 2007 019 384
- US-A1- 2007 030 656
- US-A1- 2009 229 808

## Beschreibung

Die Erfindung betrifft eine Vorrichtung zur Übertragung von Wärme zwischen einer Wärmequelle und einer Wärmesenke durch Wärmeleitung. Ein solcher Wärmeübertrager wird insbesondere in der Industrieelektronik eingesetzt, um die Verlustleistung elektronischer Komponenten abzuleiten.

Elektronische Komponenten, wie zum Beispiel Mikroprozessoren, sitzen auf Leiterplatten, die in der Regel in ein Gehäuse eingebaut werden. Bei einem so genannten Singleboard Computer sind alle wesentlichen elektronischen Komponenten des Computers auf einer einzigen Leiterplatte, dem so genannten Motherboard angeordnet. Es besteht eine Tendenz zu immer kleineren Formaten, wie zum Beispiel dem standardisierten Mini-ITX mit einer Abmessung von 170 x 170 mm, in dessen Mitte ein leistungsfähiger Prozessor sitzt.

Moderne Mehrkern-Prozessoren mit hoher Taktrate weisen eine so hohe thermische Verlustleistung auf, dass sie für einen sicheren Betrieb einer gezielten Kühlung bedürfen. Dies geschieht in der Regel mittels eines Kühlkörpers, der auf die plane Oberfläche des Prozessors aufgesetzt wird und eine Vielzahl von Kühlrippen aufweist, damit die Abwärme von einer großen Fläche durch Konvektion an die umgebende Luft abgeführt werden kann.

Für viele Anwendungszwecke müssen die elektronischen Komponenten eines Geräts in einem Gehäuse eingeschlossen werden, um es gegen Staub, Feuchtigkeit sowie Störstrahlungen zu schützen. Um dennoch die im Innern des Geräts erzeugte Abwärme nach außen abzuführen, kann das Gehäuse Lufteintritts- und Luftaustrittsöffnungen haben und/oder mit einem elektrischen Lüfter ausgestattet sein, welcher Kühlluft durch das Gehäuse hindurch bläst. In vielen Bereichen ist allerdings ein vollständig geschlossenes Gehäuse gefordert, um erhöhte Anforderungen an Staub- und Feuchtigkeitsschutz zu erfüllen.

Gehäuse für elektronische Geräte, insbesondere Industrie-Computer, mit höherer IP-Schutzklasse sind rundum dicht abgeschlossen, so dass keine Kühlluft mehr durch das Gehäuse hindurch geleitet werden kann. Stattdessen besitzen solche geschlossenen Gehäuse an ihren Außenseiten große Kühlkörper, die zum Beispiel als extrudierte Profilkörper ausgeführt sind. Es stellt sich hier das Problem, die elektronischen Komponenten im Innern des Gehäuses, also insbesondere den Prozessor oder die Prozessoren thermisch mit den Kühlkörpern an der Außenseite des Gehäuses zu verbinden, so dass die Verlustwärme durch Wärmeleitung zu den Kühlkörpern transportiert und dort durch Konvektion und/oder Wärmestrahlung an die Umgebung abgegeben werden kann.

Bekannt sind massive Metallklötze, die mit der Unterseite auf den Prozessor aufgesetzt werden und mit ihrer Oberseite an der Innenseite einer Gehäusewand anliegen, um die Wärme vom Prozessor an die Gehäusewand zu übertragen. Ein Problem hierbei sind die relativ großen Toleranzen der elektronischen und mechanischen Komponenten, insbesondere also der Prozessoren und der Bauteile des Schutzgehäuses. Schon die Bauhöhe eines marktüblichen Prozessors im eingebauten Zustand hat eine typische Toleranz von bis zu 1 mm. An der Wärmeübergangsstelle wird deshalb oft ein elastisches oder pastöses Material verwendet, das sich durch gute Wärmeleitfähigkeit auszeichnet. Die Dicke der Schicht von Wärmeleitpaste muss allerdings möglichst klein gehalten werden, denn die Wärmeleitfähigkeit auch der besten verfügbaren Produkte liegt um Größenordnungen niedriger als die Wärmeleitfähigkeit von Metall zum Beispiel Aluminium. Wird auch das andere Ende des Metallklotzes mithilfe von Wärmeleitpasten in thermischen Kontakt mit der Gehäusewand gebracht, wird der Wärmewiderstand noch größer.

Bei der Konstruktion und Produktion von standardisierten Kleingehäusen für Industriecomputer besteht eine weitere Problematik darin, dass zwar die Abmessungen der Leiterplatte festliegen, aber offen bleiben soll, welcher Prozessortyp verwendet wird. Unterschiedlich leistungsfähige Prozessoren verschiedener Hersteller wie Intel, AMD, ARM oder VIA unterscheiden sich nicht nur durch ihre elektronischen Parameter und unterschiedliche Verlustleistungen, sondern auch hinsichtlich ihrer geometrischen Abmessungen. Für diese Prozessoren werden zwar universell einsetzbare Kühlkörper und Wärmeübertrager angeboten, das hierzu erforderliche Montagematerial muss aber die Toleranzen für die gesamte Konstruktion ausgleichen. Die Toleranzen für die Dicke des Prozessors, des Sockels, des Kühlkörpers oder Übertragers und gegebenenfalls des Gehäuses summieren sich somit auf einen Wert in der Größenordnung von 2 mm oder sogar mehr. Allein mit Wärmeleitpaste oder sogenanntem gap-filler lassen sich derart große Toleranzen nicht mehr ausgleichen, wenn noch eine effektive Kühlung gewährleistet werden soll.

Eine weitere Herausforderung in diesem Zusammenhang besteht darin, dass auch bei einem vollständig geschlossenen Gehäuse zumindest der obere Deckel abnehmbar sein soll, um gegebenenfalls an die eingeschlossene Elektronik heranzukommen. Wird nach einer Reparatur der Deckel wieder aufgesetzt, muss auch die Wärmeleitung zwischen Prozessor und Deckel wieder vollständig hergestellt werden. Wärmeleitpaste ist allerdings schlecht für eine mehrfache Verwendung geeignet.

US 2007/0030656 A1 beschreibt eine Wärmeübertragungsvorrichtung mit variabler Höhe. Die Vorrichtung umfasst zwei ineinandergreifende Körper, von denen der erste Körper Kontakt zu einem Wärme abgebenden Bauteil hat und der zweite Körper in vertikaler Richtung gegenüber dem ersten Körper verschieblich ist. Zwischen den beiden Körpern sitzt eine Feder, welche den oberen Körper nach oben gegen die Innenseite eines Deckels eines Gehäuses drückt. Der Federdruck sorgt also dafür, dass der obere Körper stets Kontakt hat zu dem Gehäusedeckel, auch wenn dessen relative Höhe zum Gehäuseboden variiert, zum Beispiel aufgrund von Toleranzen bei der Herstellung. Bei der vorbekannten Vorrichtung ist der untere Wärmeleitkörper in der Art eines Kolbens und der obere Wärmeleitkörper in der Art eines Zylinders ausgebildet, welcher in dem Kolben auf- und abgleiten kann. Dadurch ergeben sich lange vertikale Spalten zwischen den beiden Körpern, welche den Wärmefluss großflächig unterbrechen. Der Spalt bzw. das Spiel zwischen den beiden Körpern darf ein gewisses Mindestmaß nicht unterschreiten, sofern nicht die Beweglichkeit der beiden Körper gegeneinander behindert oder gar unterbunden werden soll. Es wird deshalb vorgeschlagen, auf den gegeneinander gleitenden Flächen ein Schmiermittel aufzubringen, vorzugsweise ein Schmieröl mit erhöhter Wärmeleitfähigkeit.

Angesichts der geschilderten Problematik stellt sich die Aufgabe, eine verbesserte Wärmeleitvorrichtung zu schaffen, welche einen relativ großen Toleranzbereich ausgleichen kann und sich trotzdem durch maximale Wärmeleitfähigkeit auszeichnet.

Bei der Lösung der Aufgabe wird ausgegangen von einer Vorrichtung gemäß dem Oberbegriff des Patentanspruchs 1. Gelöst wird die Aufgabe durch die kennzeichnenden Merkmale des Patentanspruchs.

Der erfindungsgemäße Wärmeübertrager hat zwei massive Wärmeleitkörper, die mit variablem Abstand vertikal übereinander angeordnet sind. Zwischen den beiden Körpern sitzt wenigstens ein Spreizelement, das zwei horizontal bewegbare Keile umfasst. Die Keilspitzen weisen in entgegengesetzte Richtungen. Es ist mindestens eine Feder vorgesehen, welche die Keile entlang einer horizontalen Achse bewegt, das heißt auseinander drückt oder gegeneinander zieht. Die Wärmeleitkörper haben an ihren zueinander weisenden Seiten korrespondierende Gleitflächen, die paarweise angeordnet sind. Die Keilflächen gleiten auf den Gleitflächen der Wärmeleitkörper derart, dass eine Bewegung der Keile in horizontaler Richtung in eine vertikale Bewegung der Wärmeleitkörper umgesetzt wird. Umgekehrt führt eine vertikale Bewegung der Wärmeleitkörper infolge Drucks von außen zu einer Gleitbewegung der Keile in horizontaler Richtung gegen die Wirkung der Feder. Dabei verlaufen die Keilflächen stets parallel zu den Gleitflächen.

Die Kraft der Feder, welche durch den Druck auf den oberen Wärmeleitkörper kompensiert wird, sorgt dafür, dass die Keilflächen stets ohne nennenswerten Spalt an den Gleitflächen der Wärmeleitkörper anliegen. Trotzdem ist der vertikale Abstand zwischen den beiden Wärmeleitkörpern variabel, so dass sich die Höhe der Wärmeübertragungsvorrichtung automatisch an die baulichen Gegebenheiten anpasst, um zum Beispiel unterschiedlich hohe Prozessoren oder Fertigungstoleranzen des Gehäuses auszugleichen. Die Feder sorgt auch dafür, dass die Keilflächen der Keile stets auf die Gleitflächen der Wärmeleitkörper gepresst werden, so dass ein guter Wärmeübergang zwischen Keilen und Wärmeleitkörpern gewährleistet ist. Wärmeleitkörper und Keile ergänzen sich so zu einem fast vollständig massiven Körper mit minimalem Wärmewiderstand zwischen den außenliegenden Kontaktflächen.

Bevorzugt haben die Keile einen Querschnitt, bei dem die Keilflächen auf den Schenkeln eines gleichschenkligen Dreiecks liegen. Die Form der Keile ist damit symmetrisch in Bezug auf eine horizontale Achse, die quer zur Bewegungsrichtung der Wärmeleitkörper verläuft. Dadurch ergibt sich ein doppelt so großer Hub in vertikaler Richtung als dies bei Verwendung von Keilen mit nur einer schrägen Keilfläche der Fall wäre. Grundsätzlich sind aber auch andere Querschnittsformen für die Keile denkbar, zum Beispiel die Form eines quer liegenden rechtwinkligen Dreiecks, bei dem dann eine, vorzugsweise die obere Keilfläche schräg und die andere Keilfläche parallel zur Horizontalen verläuft.

Um auf kurzem horizontalen Weg einen großen Hub in vertikaler Richtung zu erzielen, ist es zweckmäßig, die Keilflächen in einem stumpfen Winkel anzuordnen. Dies ist möglich, da die zu bewegenden Gewichte und damit die Reibungskräfte zwischen Keilflächen und Gleitflächen relativ gering sind. Bei anderen Ausführungsformen kann eine Anordnung der Keilflächen in einem Winkel von weniger als 90 Grad vorteilhaft sein.

Aus der dreieckigen Form der Keile und ihrer gegenläufigen Bewegung ergibt sich, dass die Paare von Gleitflächen an den Wärmeleitkörpern jeweils in Form eines V bzw. umgekehrten V angeordnet sind, wobei sich der Winkel zwischen zwei aneinanderstoßenden Gleitflächen und der Winkel zwischen den Keilflächen zu 180 Grad ergänzen. Somit verlaufen die Keilflächen immer parallel zu den Gleitflächen, was wichtig ist, um einen möglichst guten Wärmekontakt zwischen den Keilen und den Wärmeleitkörpern herzustellen. Die Umlenkung der Federkraft durch die Keile in die Vertikale sorgt dafür, dass die Keilflächen unabhängig von ihrer Stellung praktisch spaltfrei plan gegen die korrespondierenden Gleitflächen gepresst werden.

Bevorzugt sitzt die Feder zwischen den Keilen angeordnet, wobei die Federkraft die Keile in horizontaler Richtung bewegt. Alternativ können auch eine oder mehrere Federn vorgesehen sein, welche auf die den Keilspitzen abgewandten Außenseiten der Keile einwirken, um diese entlang der horizontalen Achse zu bewegen und gleichzeitig gegen die Gleitflächen der Wärmeleitkörper zu drücken.

Bei einer bevorzugten Ausführung haben die zwei horizontal bewegbaren Keile des Spreizelements Keilspitzen, die voneinander weg weisen. Die zwischen den Keilen sitzende Feder drückt die Keile bevorzugt auseinander. Somit zeigen die Keilspitzen jeweils in die Richtung, in der sie durch die Feder gedrückt werden.

Die zwischen den Keilen angeordnete Feder ist vorzugsweise als Schraubenfeder ausgebildet, wobei die Federachse bevorzugt in einer horizontalen Ebene durch die Keilspitze liegt. Vorteilhaft wird man zwei oder mehr Federn parallel nebeneinander anordnen, um ein Verkanten der Keile zu verhindern.

Sind die Keile und die Keilflächen symmetrisch zu beiden Seiten derselben horizontalen Ebene angeordnet, ergibt sich eine insgesamt symmetrische Anordnung, die Vorteile hinsichtlich der Kinematik bietet, insbesondere zu einer automatischen Zentrierung der Keile in dem durch je eine Gleitfläche der beiden Wärmeleitkörper gemeinsam gebildeten Lager bewirken. Ein Verkanten der Wärmeleitkörper wird dadurch verhindert.

Die Wärmeleitkörper können durch eine Führung so miteinander verbunden sein, dass sie im Wesentlichen nur in vertikaler Richtung gegeneinander beweglich sind, seitlich jedoch nicht ausweichen können. Diese Vertikalführung kann vorteilhaft einen Anschlag haben, der die maximale gegenseitige Verschiebung der Wärmeleitkörper begrenzt. Auch bei vollständig entspannter Feder, also maximal möglichem Abstand der Wärmeleitkörper voneinander, wird dadurch ein Auseinanderfallen der Vorrichtung verhindert, die Montage wird vereinfacht.

Anstelle einer einzigen Spreizvorrichtung mit zwei Keilen und mindestens einer Feder können auch zwei gleich ausgebildete Spreizelemente horizontal nebeneinander angeordnet sein. In diesem Fall haben die beiden Wärmeleitkörper jeweils zwei Paare von V-förmig angeordneten Gleitflächen, auf denen die Keile je eines der beiden Spreizelemente gleiten. Insbesondere für etwas breitere Wärmeübertragungsvorrichtungen ist die Anordnung von zwei gleichen Spreizelementen vorteilhaft, da damit automatisch eine über die Breite konstante Verspannung der beiden Wärmeleitkörper zueinander gewährleistet ist. Für noch breitere Vorrichtungen ist es auch denkbar, mehr als zwei Spreizelemente horizontal nebeneinander anzuordnen.

Die Wärmeleitkörper werden bevorzugt einstückig als Strangpressprofil hergestellt. Das Material ist vorzugsweise ein Metall mit sehr guter Wärmeleitfähigkeit, insbesondere Aluminium oder Kupfer. Auch die Keile können einstückig als Strangpressprofil aus demselben oder einem anderen, gut wärmeleitfähigen Material hergestellt werden.

Besonders vorteilhaft ist es, wenn beide Wärmeleitkörper aus dem gleichen Strangpressprofil hergestellt sind. Der obere Wärmeleitkörper unterscheidet sich dann von dem unteren Wärmeleitkörper allein dadurch, dass er um 180 Grad gedreht angeordnet ist. Da auch die Keile gleich ausgebildet sind, kann die gesamte Vorrichtung im Wesentlichen aus nur drei verschiedenen Teilen hergestellt werden, nämlich aus zwei gleichen Wärmeleitkörpern, wenigstens zwei gleichen Keilen und einer Feder oder mehreren gleichen Federn. Die optionale Vertikalführung für die Wärmeleitkörper mitsamt Anschlag kann dabei durch einstückig an die Wärmeleitkörper angeformte Stege ausgebildet werden, so dass auch hierfür keine weiteren Teile hergestellt werden müssen.

Bei einer alternativen Ausführung der erfindungsgemäßen Wärmeübertragungsvorrichtung sind die zwei horizontal bewegbaren Keile der mindestens einen Spreizvorrichtung so angeordnet, dass die Keilspitzen gegeneinander weisen. In diesem Falle ist es zweckmäßig, dass die Keile von der Feder nicht auseinander gedrückt, sondern gegeneinander gezogen werden. Auch hier wirkt also die Feder in die Richtung, in welche die Keilspitzen weisen. In allen Fällen ist eine Bewegung der Keile in horizontaler Richtung mit einer vertikalen Bewegung der Wärmeleitkörper verkoppelt und umgekehrt.

Anstelle einer Schraubenfeder kann die Feder des mindestens einen Spreizelements auch als Gummifeder ausgebildet sein, welche die beiden Keile miteinander verbindet. Eine solche, vorzugsweise massiv ausgebildete Gummifeder besteht zweckmäßig aus einem hochelastischen Material wie zum Beispiel einem Elastomer. Wird die Gummifeder auseinander gezogen, baut sie in Abhängigkeit ihrer Dehnung eine Zugkraft auf, welche die Keile gegeneinander zieht. Bei Verwendung einer Feder aus gummielastischem Material kann die Konstruktion besonders einfach ausgeführt werden. Anstelle einer zentralen Feder können auch mehrere Federn parallel nebeneinander angeordnet werden.

Grundsätzlich ist es natürlich auch möglich, die Keile von einer über die Ruhelage hinaus ausgelenkten Schraubenfeder aus Federstahl zusammenziehen zu lassen.

Bevorzugt weisen die Keile im Bereich ihrer Keilspitzen Befestigungsnuten auf, die quer zur Bewegungsrichtung verlaufen, und hat die Gummifeder an zwei gegenüberliegenden Enden Wülste, welche formschlüssig in den Befestigungsnuten sitzen und damit eine Übertragung der Zugkraft auf die beweglichen Keile ermöglicht. Speziell bei kleinen Abmessungen der Wärmeübertragungsvorrichtung hat diese Bauart Vorteile, da die gesamte Konstruktion auf vier einfache Metallteile und ein elastisches Federelement reduziert werden kann. Dadurch ist es möglich, besonders kleine und/oder kostengünstige Vorrichtungen zu bauen.

Bei einer besonders bevorzugten Ausführung haben die Wärmeleitkörper an ihren zueinander gewandten Seiten Führungsnuten, welche quer zur Bewegungsrichtung der Wärmeleitkörper und parallel zu den Befestigungsnuten der Keile verlaufen, und weist die Gummifeder einen Querschnitt in Form eines Kreuzes mit einer horizontalen und einer vertikalen Linie auf, wobei die Wülste an den Enden der horizontalen Linie angeordnet sind und die Endbereiche der vertikalen Linie in die Führungsnuten der Wärmeleitkörper eingreifen. Die Führungsnuten und die vertikalen Linien der im Querschnitt kreuzförmigen Gummifeder bilden so eine Führung für die Wärmeleitkörper in vertikaler Richtung, während die horizontalen Linien des Kreuzes die eigentliche Zugfeder bilden.

In weiterer, vorteilhafter und zweckmäßiger Ausführung haben die Führungsnuten der Wärmeleitkörper einen hinterschnittenen Querschnitt und weist die kreuzförmige Gummifeder an den Enden der vertikalen Linien des Kreuzes wulstartige Verdickungen auf, welche in den Führungsnuten sitzen. Dabei bleiben die wulstartigen Verdickungen in den Führungsnuten in vertikaler Richtung beweglich, um einen variablen Abstand der Wärmeleitkörper zueinander zu ermöglichen.

Wenn hier von "horizontal" und "vertikal" gesprochen wird, so geschieht dies zur Bestimmung der Anordnung und Bewegungsrichtungen der einzelnen Bauelemente der Vorrichtung relativ zueinander, und nicht etwa zur Definition der absoluten Winkellage im Raum. Grundsätzlich ist es nämlich möglich, die erfindungsgemäße Wärmeübertragungsvorrichtung beliebig im Raum anzuordnen, also beispielsweise auch zwischen zwei vertikal oder schräg im Raum stehenden Flächen zweier Körper, zwischen denen Wärme übertragen werden soll. Prozessoren von Computern werden allerdings in der Regel so in ein Gehäuse eingebaut, dass ihre Oberseite, von der die Wärme abgeführt werden muss, tatsächlich ungefähr horizontal im Raum ausgerichtet ist, und dass insoweit die beiden Wärmeleitkörper der erfindungsgemäßen Vorrichtung auch real ungefähr vertikal übereinander angeordnet sind. Schutz beansprucht wird jedenfalls auch für Wärmeübertragungsvorrichtungen, bei denen zum Beispiel die Wärmeleitkörper entlang einer horizontalen Achse einander gegenüberstehen und dementsprechend die Keile des mindestens einen Spreizelements entlang einer vertikalen Achse - und damit rechtwinklig bzw. quer zur Bewegungsrichtung der Wärmeleitkörper - bewegbar sind, so dass eine Bewegung der Keile in vertikaler Richtung in eine horizontale Bewegung der Wärmeleitkörper umgesetzt wird.

Ausführungsbeispiele der Erfindung werden nun anhand der beigefügten Zeichnungen im Detail erläutert. Es zeigen:
- Figur 1 a: eine erste Vorrichtung zur Übertragung von Wärme, in isometrischer Darstellung;
- Figur 1b: die Vorrichtung von Figur 1a, in Seitenansicht;
- Figur 2a: das Profil der Wärmeleitkörper der Vorrichtung von Figur 1a;
- Figur 2b: die beiden Wärmeleitkörper von Figur 1a, zusammengesetzt;
- Figur 3a, 3b: die Vorrichtung von Figur 1a, in zusammengedrücktem bzw. auseinandergeschobenem Zustand;
- Figur 4a, 4b: eine alternative Vorrichtung zur Übertragung von Wärme in zusammengedrücktem bzw. auseinandergeschobenem Zustand, jeweils in Seitenansicht;
- Figur 5a, 5b: eine Modifikation der Vorrichtung von Figur 4a, 4b;
- Figur 6a, 6b, 6c: den Einsatz einer Wärmeübertragungsvorrichtung gemäß Figur 1 a in einem Gehäuse, perspektivisch;
- Figur 7: das Gehäuse mit eingebauter Wärmeübertragungsvorrichtung gemäß Figur 6a, in einem Vertikalschnitt.
- Figur 8a, 8b: eine dritte Vorrichtung zur Übertragung von Wärme in zusammengedrücktem bzw. auseinandergeschobenem Zustand, jeweils in Seitenansicht;
- Figur 9a, 9b: eine vierte Vorrichtung zur Übertragung von Wärme, perspektivisch bzw. in einer Explosionszeichnung;
- Figur 10a, 10b: die Vorrichtung von Figur 9a in auseinandergeschobenem bzw. zusammengedrücktem Zustand, jeweils in Seitenansicht.

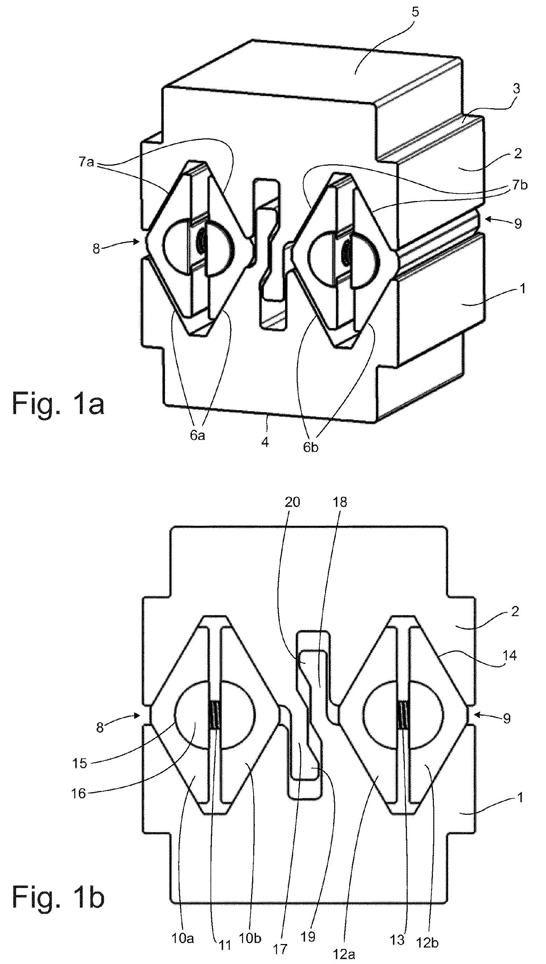

Figur 1 a zeigt einen Wärmeübertrager mit einem ersten Wärmeleitkörper 1 und einem zweiten, mit Abstand vertikal darüber angeordneten Wärmeleitkörper 2. Die beiden Wärmeleitkörper 1, 2 haben im Wesentlichen die Form eines rechteckigen Quaders, wobei die schmalen Stirnseiten eine Abstufung 3 aufweisen, so dass die Breite der Wärmeleitkörper 1, 2 im Bereich ihrer gegenüberliegenden Enden etwas reduziert ist. Die Unterseite des unteren Wärmeleitkörpers 1 bildet eine erste ebene Kontaktfläche 4, die Oberseite des oberen Wärmeleitkörpers 2 eine zweite ebene Kontaktfläche 5. Diese Kontaktflächen 4, 5 dienen zur Herstellung eines flächigen Kontakts zu einem (nicht dargestellten) Bauteil, von dem Wärme abgeführt werden soll, bzw. zu einem Bauelement, wie zum Beispiel einen Gehäusedeckel, das Wärme aufnehmen kann. Der Wärmegradient entlang der vertikalen Achse des Wärmeübertragers verursacht einen Wärmefluss zwischen den beiden Kontaktflächen 4, 5 von unten nach oben oder in umgekehrter Richtung, also von oben nach unten.

An den jeweils den Kontaktflächen 4, 5 gegenüberliegenden Seiten der Wärmeleitkörper 1, 2 sind jeweils zwei Paare von Gleitflächen 6a, 6b bzw. 7a, 7b ausgebildet. Die Gleitflächen 6a, 6b des unteren Wärmeleitkörpers sind in Form eines V angeordnet; die Gleitflächen 7a, 7b des oberen Wärmeleitkörpers sind ebenfalls V-förmig angeordnet, wobei das V allerdings auf dem Kopf steht. Dies bedeutet, dass die Gleitflächen 6a, 6b, 7a, 7b auf den Schenkeln von insgesamt vier gleichschenkligen Dreiecken angeordnet sind, wobei die Spitzen von jeweils zwei Dreiecken in entgegengesetzte Richtungen weisen, so dass insgesamt zwei Rauten gebildet werden.

Zwischen den Wärmeleitkörpern 1, 2 sitzen zwei Spreizelemente 8 und 9, welche horizontal nebeneinander angeordnet sind. Das in den Figuren 1a, 1b linke Spreizelement 8 umfasst zwei Keile 10a, 10b mit voneinander wegweisenden Keilspitzen sowie eine zwischen den Keilen angeordnete Feder 11. Das gleich ausgebildete zweite Spreizelement 9 (in Figur 1 b rechts) umfasst ebenfalls zwei Keile 12a, 12b mit auseinanderweisenden Spitzen und eine zwischengesetzte Feder 13. Die hier als Schraubenfedern ausgebildeten Federn 11, 13 drücken die zugehörigen Keile 10a, 10 bzw. 12a, 12b in horizontaler Richtung auseinander. Dabei gleiten die Keilflächen 14 auf den jeweils zugeordneten Gleitflächen 6a, 6b des unteren Wärmeleitkörpers 1 bzw. auf den Gleitflächen 7a, 7b des oberen Wärmeleitkörpers 2. Die Keilflächen 14 und die zugehörige Gleitflächen 6a, 6b bzw. 7a, 7b verlaufen dabei parallel, das heißt, sie liegen vollflächig und nahezu ohne Spalt aufeinander.

Wie insbesondere aus dem Schnittbild von Figur 1b ersichtlich, haben die Keile 10a, 10b, 12a, 12b an ihren den Keilspitzen gegenüberliegenden Rückseiten halbrunde Nuten 15, in denen Leisten 16 sitzen, deren Querschnitt ebenfalls halbkreisförmig ist. Die Federn 11, 13 stützen sich gegen die ebenen Oberseiten der Leisten 16 ab. Dabei können sich die Leisten 16 in den Nuten 15 etwas verdrehen und so eine nicht exakt horizontale Ausrichtung der Wärmeleitkörper 1 und 2 gegeneinander ausgleichen.

Die Wärmeleitkörper 1, 2 weisen an ihren gegeneinander weisenden Innenseiten spiegelbildlich geformte, jedoch seitlich etwas versetzt angeordnete Führungsstege 17, 18 auf, welche eine vertikale Führung für die Wärmeleitkörper 1, 2 bilden. An ihren freien Enden sind die Führungsstege 17, 18 nach außen abgewinkelt, wodurch horizontale Anschläge 19 bzw. 20 gebildet werden. Diese Anschläge 19, 20 begrenzen den Weg, den sich der obere Wärmeleitkörper 2 vom unteren Wärmeleitkörper 1 in vertikaler Richtung entfernen kann, wobei sich die Führungsstege 17, 18 parallel verschieben und damit eine rein vertikale Verschiebung der Wärmeleitkörper 1, 2 gegeneinander vorgeben.

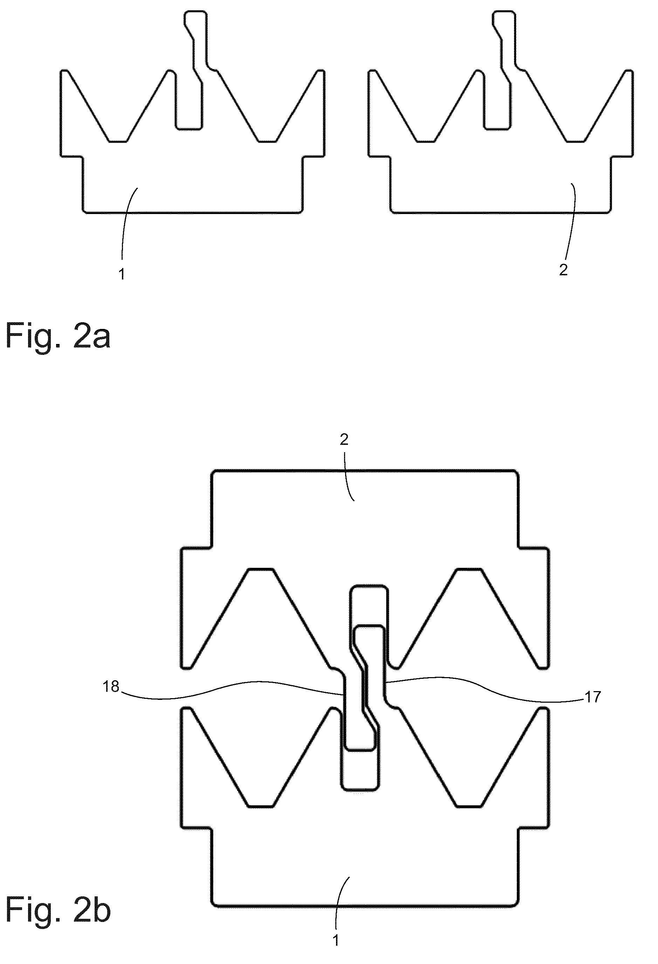

In Figur 2a sind die beiden Wärmeleitkörper 1, 2 separat dargestellt. Sie sind einstückig aus demselben Strangpressprofil hergestellt. In Figur 2a sind die beiden Wärmeleitkörper 1, 2 nebeneinander angeordnet, wohingegen Figur 2b die beiden Wärmeleitkörper 1 und 2 zusammengesetzt zeigen. Hierzu wurde der obere Wärmeleitkörper 2 um 180 Grad gedreht auf den unteren Wärmeleitkörper 1 aufgeschoben.

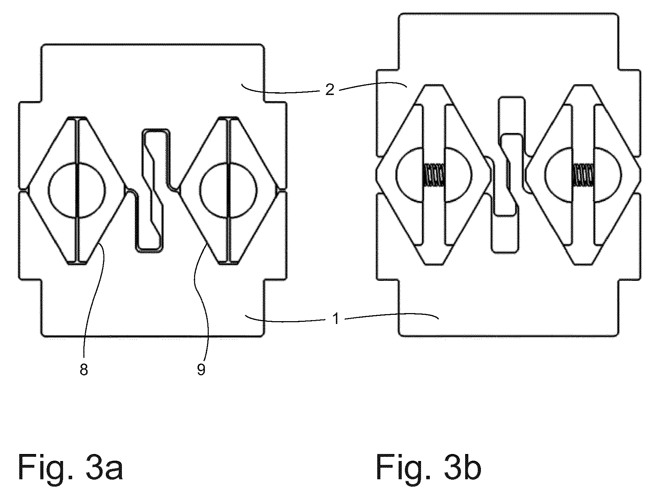

Die Figuren 3a und 3b verdeutlichen die Funktion des zuvor beschriebenen Wärmeübertragers. In der linken Abbildung Figur 3a stoßen die beiden Wärmeleitkörper 1, 2 fast aneinander, haben also minimalen Abstand, so dass die gesamte Vorrichtung minimale Höhe hat. In der Abbildung Figur 3b rechts daneben haben sich die beiden Wärmeleitkörper 1, 2 in vertikaler Richtung maximal voneinander entfernt, so dass die Vorrichtung maximale Höhe hat. Der Unterschied zwischen minimaler und maximaler Höhe ergibt den variablen Abstand zweier (nicht dargestellter) Bauteile, die durch die Vorrichtung zwecks Übertragung von Wärme verbunden werden können. Dabei sorgen die Federn 11, 13 dafür, dass eine Bewegung der Keile 10a, 10b bzw. 12a, 12b in horizontaler Richtung in eine vertikale Bewegung der Wärmeleitkörper 1, 2 in vertikaler Richtung gegeneinander umgesetzt wird. In Figur 3a sind die Federn 11, 13 maximal zusammengedrückt, während sie in Figur 3b fast vollständig entspannt sind. Die Anschläge 19, 20 an den Führungsstegen 17, 18 begrenzen die vertikale Bewegung des oberen Wärmeleitkörpers 2 relativ zum unteren Wärmeleitkörper 1.

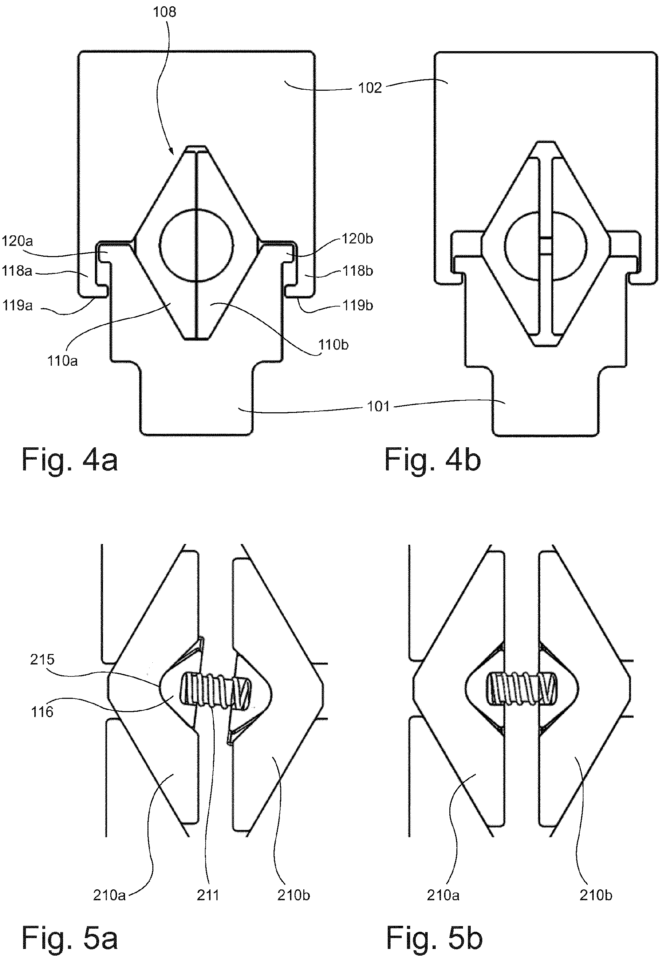

Die Schnittbilder der Figuren 4a, 4b zeigen eine alternative Ausführungsform des Wärmeübertragers. Auch diese Vorrichtung umfasst einen unteren Wärmeleitkörper 101 und einen oberen Wärmeleitkörper 102, der mit variablem Abstand vertikal über dem ersten Wärmeleitkörper 101 angeordnet ist. Der untere Wärmeleitkörper 101 ist etwas schmaler als der obere Wärmeleitkörper 102. Im Gegensatz zu der ersten Ausführungsform gemäß Figur 1a hat diese zweite Ausführungsform nur ein einziges Spreizelement 108, das zwischen den beiden Wärmeleitkörpern 101, 102 angeordnet ist und zwei horizontal bewegbare Keile 110a, 110b umfasst, deren Keilspitzen in entgegengesetzte Richtungen weisen.

Bei der Ausführungsform gemäß den Figuren 4a, 4b sind nur an dem oberen Wärmeleitkörper 102 rechts und links Führungsstege 118a, 118b angeformt, welche den unteren Wärmeleitkörper 101 seitlich ein Stück umgreifen. Die Führungsstege 118a, 118b haben an ihren freien Enden nach innen gerichtete Abkantungen, welche Anschläge 119a, 119b bilden. Diese wirken mit Gegenanschlägen 120a, 120b am unteren Wärmeleitkörper 101 zusammen.

Das Spreizelement 108 ist im Prinzip gleich ausgebildet wie die zwei Spreizelemente 8, 9 der ersten Ausführungsform des Wärmeübertragers (vgl. Figur 1a, Figur 1b). Insbesondere umfasst das Spreizelement 108 neben den Keilen 110a, 110b eine (hier nicht dargestellte) Feder, welche die Keile 110a, 110b in horizontaler Richtung auseinanderdrückt.

Auch bei der Ausführung gemäß den Figuren 4a, 4b bewirkt die Bewegung der Keile 110a, 110b in horizontaler Richtung eine vertikale Verlagerung des oberen Wärmeleitkörpers 102 gegenüber dem unteren Wärmeleitkörper 101.

Während in Figur 4a die beiden Wärmeleitkörper 101, 102 minimalen Abstand haben, haben sie sich in Figur 4b maximal voneinander entfernt.

Die Detailansichten der Figuren 5a und 5b zeigen eine modifizierte Ausführung der Spreizelemente 8, 9 bzw. 108. Die Keile 210a, 210b haben hier Nuten, die nicht halbkreisförmigen Querschnitt haben, sondern einen Querschnitt in Form eines gleichschenkligen Dreiecks mit verrundeter Spitze aufweisen. Die in den Nuten 215 sitzenden Leisten 216 haben ebenfalls einen Querschnitt in Form eines gleichschenkligen Dreiecks, wobei der von den Schenkeln dieses Dreiecks eingeschlossene Winkel etwas kleiner ist als der entsprechende Winkel der Nuten 215. Bei einer Schrägstellung der Feder 211, wie in Figur 5a dargestellt, können die Leisten 216 um einen entsprechenden Winkel kippen. Dadurch kann ein Höhenversatz zwischen dem linken Keil 210a und dem rechten Keil 210b ausgeglichen werden.

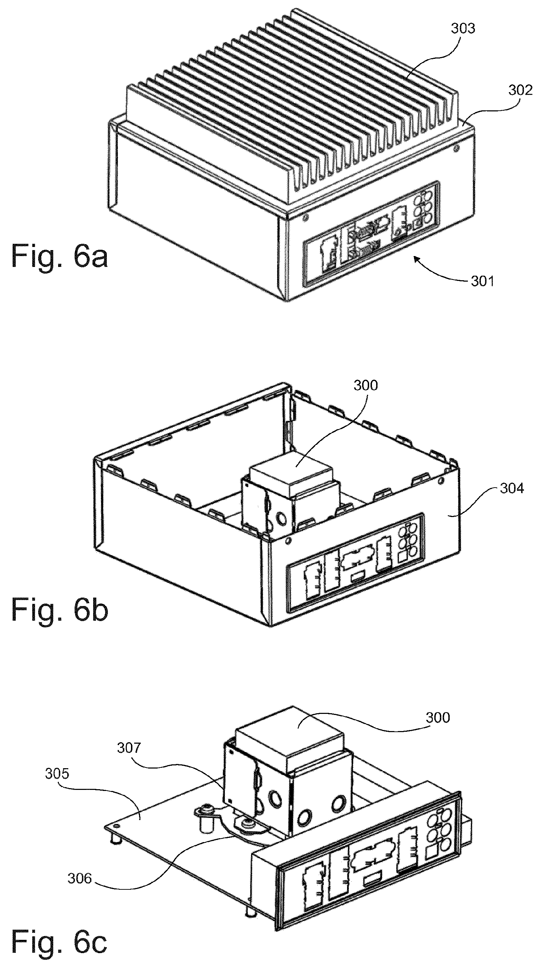

Die Figuren 6a, 6b und 6c erläutern die Verwendung einer Wärmeübertragungsvorrichtung 300 der zuvor beschriebenen Art.

Figur 6a zeigt ein geschlossenes Gehäuse 301 zum Einbau elektronischer Bauelemente, insbesondere eines Mini-ITX Singleboard Computers. Die Oberseite des Deckels 302 des Gehäuses 301 wird fast ganz von einem Kühlkörper 303 eingenommen, der eine Vielzahl von Kühlrippen aufweist und damit eine große Kühlfläche hat.

In Figur 6b ist der Kühlkörper 303 abgenommen, so dass der Blick in das Innere des Gehäuses 301 frei wird. In Figur 6c sind zudem die Seitenwände 304 weggelassen, so dass das Motherboard 305 zu sehen ist. In dessen Mitte sitzt ein Prozessor 306, dessen Verlustwärme abgeführt werden muss. Zu diesem Zwecke ist die Wärmeübertragungsvorrichtung 300 auf die flache Oberseite des Prozessors 306 aufgesetzt. In Figur 6c ist der untere Wärmeleitkörper der Vorrichtung 300 verdeckt durch einen Montageadapter 307. Die Bewegung des oberen Wärmeleitkörpers gegenüber dem unteren Wärmeleitkörper, der fest mit dem Prozessor 306 verbunden ist, wird durch den Montageadapter 307 nicht behindert.

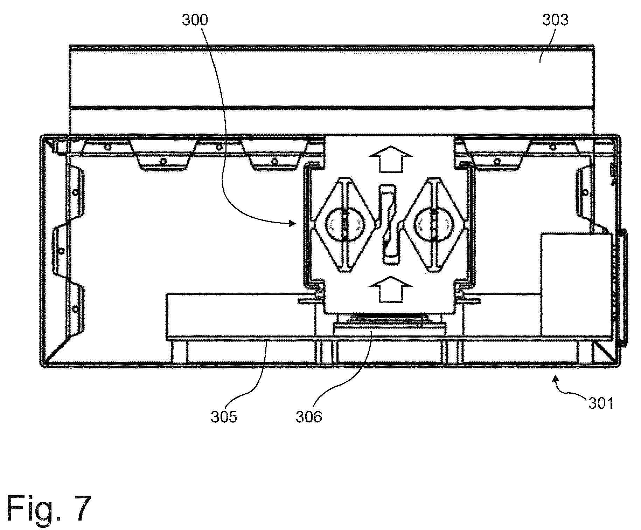

In Figur 7 sind die Federn der Spreizelemente teilweise entspannt, so dass die ebene Oberseite der Wärmeübertragungsvorrichtung 300 federnd gegen die Unterseite des Kühlkörpers 303 gepresst wird. Maßliche Abweichungen sowohl des Prozessors 306 als auch in der Konstruktion des Gehäuses 301 werden somit automatisch ausgeglichen, indem sich die Höhe des Wärmeübertragers 300 automatisch anpasst.

Aus dem Querschnitt von Figur 7 wird deutlich, wie die in das Gehäuse 301 eingesetzte Wärmeübertragungsvorrichtung 300 die vom Prozessor 306 abgegebene Verlustwärme nach oben zum Kühlkörper 303 leitet. Der Wärmefluss wird durch die breiten Pfeile symmetrisch.

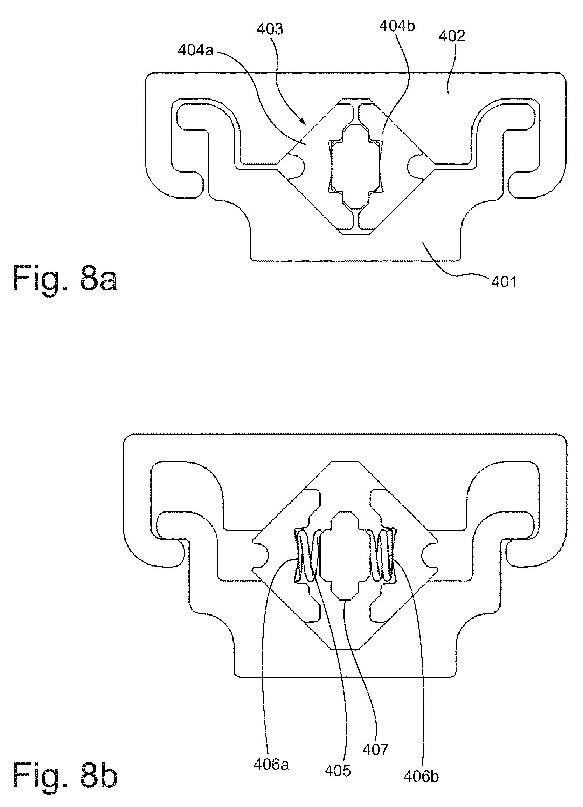

Die in den Figuren 8a, 8b dargestellte dritte Ausführungsform einer erfindungsgemäßen Wärmeübertragungsvorrichtung folgt demselben konstruktiven Prinzip wie die Vorrichtung gemäß Figuren 4a, 4b. Die Vorrichtung hier ist allerdings flacher ausgeführt und ist für kleinere Abmessungen optimiert.

Zwischen einem unteren Wärmeleitkörper 401 und einem oberen Wärmeleitkörper 402 ist ein Spreizelement 403 angeordnet. Dieses umfasst zwei Keile 404a, 404b, deren (gedachte) Spitzen in entgegengesetzte Richtungen, nämlich nach Außen weisen. Zwischen den Keilen 404a, 404b sind mehrere Federn 405 parallel nebeneinander angeordnet, von denen allerdings in den Abbildungen nur die vorderste Feder 405 zu sehen ist. An den gegeneinander weisenden Innenseiten der Keile 404a, 404b sind flache rechteckige Nuten 406a, 406b ausgebildet, welche die Enden der Federn 405 aufnehmen und seitlich fixieren. Die Federn 405 sind Schraubenfedern aus Metall.

In zusammengeschobenem Zustand der Vorrichtung (Figur 8a) sind die Federn 405 zusammengedrückt, während die Federn 405 bei maximalem Abstand zwischen unterem Wärmeleitkörper 401 und oberem Wärmeleitkörper 402 (vgl. Figur 8b) teilweise entspannt sind. Die Federn 405 sind von Führungselementen 407 aus Kunststoff oder Metall umgeben, welche die Federn 405 positionieren und axial stabilisieren und gleichzeitig als Anschläge für die Keile 404a, 404b dienen (vgl. Figur 8a).

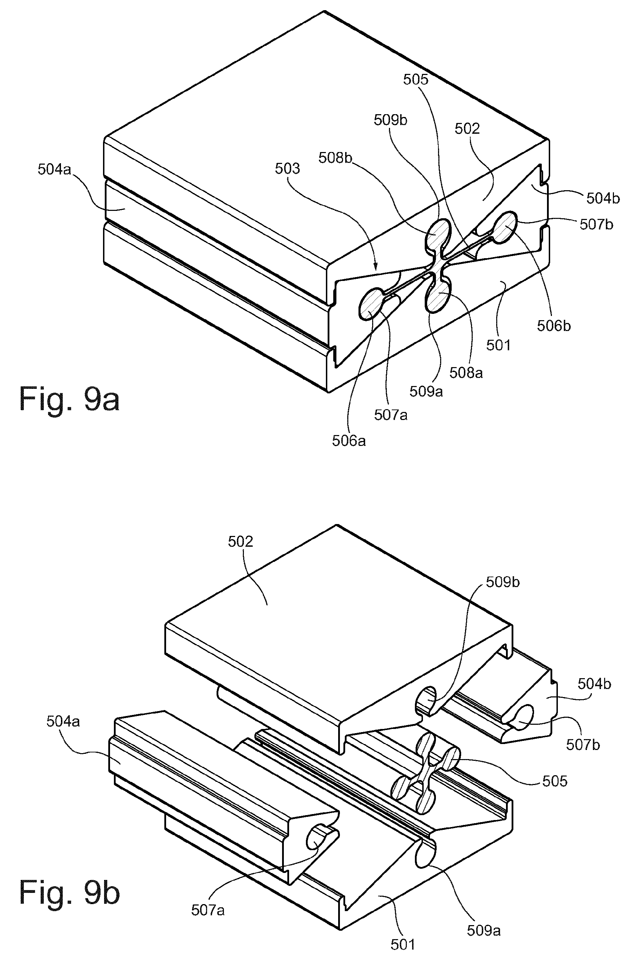

Eine weitere, noch einfacher konstruierte Vorrichtung zur Übertragung von Wärme ist in den Figuren 9a und 9b dargestellt. Diese vierte Variante ist speziell für sehr kleine Abmessungen optimiert.

Ein unterer Wärmeleitkörper 501 und ein oberer Wärmeleitkörper 502 haben V-förmigen Querschnitt und sind spiegelbildlich zueinander so angeordnet, dass die V-Spitzen gegeneinander weisen. Das zwischen den Wärmeleitkörpern 501, 502 angeordnete Spreizelement 503 besteht aus zwei kleinen Keilen 504a, 504b, deren (gedachte) Spitzen gegeneinander weisen. Die von den Keilflächen der Keile 504a, 504b eingeschlossenen Winkel betragen hier nur ungefähr 40 Grad. Zwischen den Keilen 504a, 504b ist eine Gummifeder 505 angeordnet.

Die Explosionszeichnung von Figur 9b lässt die Geometrien der insgesamt nur fünf Einzelteile der Vorrichtung erkennen. Die Gummifeder 505 ist einstückig aus einem hochelastischen Elastomer-Kunststoff hergestellt und hat einen Querschnitt in Form eines Kreuzes mit einer horizontalen und einer vertikalen Linie. An den gegenüberliegenden Enden der horizontalen Linie des Kreuzes sind Wülste 506a und 506b ausgebildet. Die identischen Querschnitt aufweisenden, jedoch spiegelbildlich angeordneten Keile 504a, 504b weisen in Bereich ihrer Keilspitzen Befestigungsnuten 507a bzw. 507b auf, welche quer zur Bewegungsrichtung verlaufen. Die Wülste 506a, 506b der Gummifeder 505 sitzen formschlüssig in den Befestigungsnuten 507a, 507b. Dadurch wird es möglich, dass die Gummifeder 505 die Keile 504a, 504b gegeneinander zieht. Wird der obere Wärmeleitkörper 502 auf den unteren Wärmeleitkörper 501 gedrückt, so führt dies automatisch dazu, dass die Keile 504a, 504b auseinander gleiten, wodurch die Gummifeder 505 in die Länge gezogen wird und eine elastische Rückstellkraft aufbaut.

Die Endbereiche der vertikalen Linie des Kreuzes, das die Querschnittsform der Gummifeder 505 darstellt, gehen in wulstartige Verdickungen 508a, 508b über. Die Wärmeleitkörper 501, 502 haben korrespondierende Führungsnuten 509a bzw. 509b, in welche die wulstartigen Verdickungen 508a, 508b eingreifen. Anders als die Wülste 506a, 506b gehen die Verdickungen 508a, 508b allerdings keine formschlüssigen Verbindungen mit den Führungsnuten 509a, 509b ein, sondern sitzen in letzteren mit Spiel insbesondere in vertikaler Richtung. Dadurch bilden die vertikalen Arme der Gummifeder 505 zusammen mit den Führungsnuten 509a, 509b Vertikalführungen für die Wärmeleitkörper 501, 502.

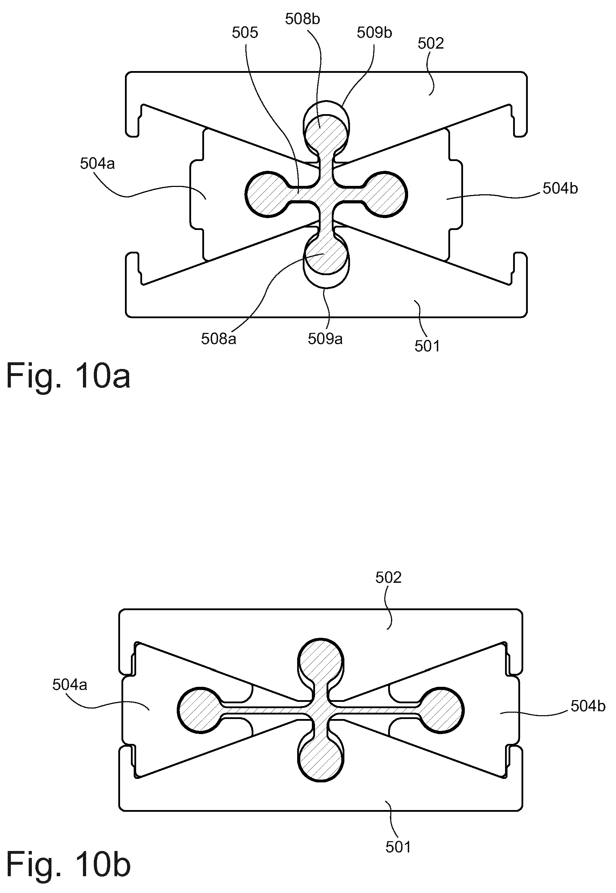

In Figur 10a hat die Wärmeübertragungsvorrichtung ihre maximale Höhe; die beiden Wärmeleitkörper 501, 502 haben größtmöglichen Abstand voneinander. In diesem Zustand stoßen die Spitzen der Keile 504a, 504b fast zusammen, die X-förmige Gummifeder 505 ist entspannt.

In Figur 10b sind die beiden Wärmeleitkörper 501 und 502 ganz zusammengedrückt, die Vorrichtung hat minimale Höhe. Die Keile 504a, 504b haben nun maximalen Abstand voneinander und die Gummifeder 505 ist maximal in die Länge gezogen.

Ein Vergleich zwischen Figur 10a und Figur 10b zeigt die Funktion der Führungsnuten 509a, 509b im Zusammenwirken mit den vertikalen Armen der Gummifeder 505 und den an den Enden angeordneten wulstartigen Verdickungen 508a, 508b.

### Bezugszeichen

- 1: unterer Wärmeleitkörper
- 2: oberer Wärmeleitkörper
- 3: Abstufung
- 4: Kontaktfläche (von 1)
- 5: Kontaktfläche (von 2)
- 6a, 6b: Gleitflächen (von 1)
- 7a, 7b: Gleitflächen (von 2)
- 8: Spreizelement
- 9: Spreizelement
- 10a, 10b: Keile (von 8)
- 11: Feder (von 8)
- 12a, 12b: Keile (von 9)
- 13: Feder (von 9)
- 14: Keilflächen (von 8, 9)
- 15: Nuten
- 16: Leisten
- 17: Führungssteg (von 1)
- 18: Führungssteg (von 2)
- 19: Anschlag (von 17)
- 20: Anschlag (von 18)

- 101: unterer Wärmeleitkörper
- 102: oberer Wärmeleitkörper
- 108: Spreizelement
- 110a, 110b: Keile (von 108)
- 118a, 118b: Führungsstege
- 119a, 119b: Anschläge
- 120a, 120b: Gegenanschläge
- 210a, 210b: Keile
- 211: Feder
- 215: Nuten
- 216: Leisten

- 300: Wärmeübertragungsvorrichtung
- 301: Gehäuse
- 302: Deckel
- 303: Kühlkörper
- 304: Seitenwände
- 305: Motherboard
- 306: Prozessor
- 307: Montageadapter

- 401: unterer Wärmeleitkörper
- 402: oberer Wärmeleitkörper
- 403: Spreizelement
- 404a,404b: Keile (von 403)
- 405: Federn
- 406a, 406b: Nuten (in 404a, 404b)
- 407: Führungselemente

- 501: unterer Wärmeleitkörper
- 502: oberer Wärmeleitkörper
- 503: Spreizelement
- 504a, 504b: Keile (von 503)
- 505: Gummifeder
- 506a, 506b: Wülste (von 505)
- 507a, 507b: Befestigungsnuten
- 508a, 508b: Verdickungen (von 505)
- 509a, 509b: Führungsnuten

## Patentansprüche

1. Vorrichtung zur Übertragung von Wärme, mit
zwei massiven Wärmeleitkörpern (1, 2; 101, 102; 401, 402; 501, 502), die mit variablem Abstand vertikal übereinander angeordnet sind, einem federelastischen Element, durch das die beiden Wärmeleitkörper (1, 2; 101, 102; 401, 402; 501, 502) auseinander gedrückt werden,
**dadurch gekennzeichnet, dass**
zwischen den Wärmeleitkörpern (1, 2; 101, 102; 401, 402; 501, 502) wenigstens ein Spreizelement (8, 9, 108, 403, 503) sitzt, das zwei horizontal bewegbare Keile (10a, 10b; 12a, 12b; 110a, 110b; 404a, 404b; 504a, 504b) mit in entgegengesetzte Richtungen weisenden Keilspitzen umfasst sowie mindestens eine Feder (11, 13, 405, 505), welche die Keile (10a, 10b; 12a, 12b; 110a, 110b; 404a, 404b; 504a, 504b) entlang einer horizontalen Achse bewegt,
die Wärmeleitkörper (1, 2; 101, 102; 401, 402; 501, 502) an ihren zueinander weisenden Seiten jeweils mindestens ein Paar von Gleitflächen (6a, 6b; 7a, 7b) haben, welche parallel zu den Keilflächen (14) verlaufen und auf denen die Keile (10a, 10b; 12a, 12b; 110a, 110b; 404a, 404b; 504a, 504b) gleiten, so dass eine Bewegung der Keile in horizontaler Richtung in eine vertikale Bewegung der Wärmeleitkörper umgesetzt wird.

2. Vorrichtung nach Anspruch 1, **dadurch gekennzeichnet, dass** die Keile (10a, 10b; 12a, 12b; 110a, 110b; 404a, 404b; 504a, 504b) einen Querschnitt haben, bei dem die Keilflächen (14) auf den Schenkeln eines gleichschenkligen Dreiecks liegen,

3. Vorrichtung nach Anspruch 2, **dadurch gekennzeichnet, dass** die Keilflächen (14) in einem stumpfen Winkel zueinander stehen.

4. Vorrichtung nach einem der vorhergehenden Ansprüche, **dadurch gekennzeichnet, dass** die Paare von Gleitflächen (6a, 6b; 7a, 7b) an den Wärmeleitkörpern (1, 2; 101, 102; 404, 402; 501, 502) jeweils V-förmig angeordnet sind, wobei sich der Winkel zwischen zwei aneinanderstoßenden Gleitflächen (6a, 6b, 7a, 7b) und der Winkel zwischen den zugeordneten Keilflächen (14) zu 180 Grad ergänzen.

5. Vorrichtung nach einem der Ansprüche, **dadurch gekennzeichnet, dass** die zwei horizontal bewegbaren Keile (10a, 10b; 110a, 110b; 404a, 404b) voneinander weg weisende Keilspitzen haben.

6. Vorrichtung nach einem der vorhergehenden Ansprüche, **dadurch gekennzeichnet, dass** die Feder (11, 13, 405, 505) zwischen den Keilen (10a, 10b; 12a, 12b; 110a, 110b; 404a, 404b; 504a, 504b) angeordnet ist.

7. Vorrichtung nach einem der vorhergehenden Ansprüche, **dadurch gekennzeichnet, dass** die Feder (11, 13, 211, 405) die Keile (10a, 10b; 110a, 110b; 404a, 404b) auseinander drückt.

8. Vorrichtung nach einem der vorhergehenden Ansprüche, **dadurch gekennzeichnet, dass** die Feder (13, 211) eine Schraubenfeder ist, deren Federachse in einer horizontalen Ebene durch die Keilspitzen liegt.

9. Vorrichtung nach einem der vorhergehenden Ansprüche, **dadurch gekennzeichnet, dass** die Wärmeleitkörper (1, 2; 101, 102; 401, 402; 501, 502) durch eine Führung so miteinander verbunden sind, dass sie im Wesentlichen nur in vertikaler Richtung gegeneinander beweglich sind.

10. Vorrichtung nach Anspruch 9, **dadurch gekennzeichnet, dass** die Führung einen Anschlag (19, 20; 119a, 119b) hat, der die Bewegung in vertikaler Richtung begrenzt.

11. Vorrichtung nach einem der vorhergehenden Ansprüche, **dadurch gekennzeichnet, dass**
zwei Spreizelemente (8, 9) horizontal nebeneinander angeordnet sind. die beiden Wärmeleitkörper (1, 2) jeweils zwei Paare von V-förmig angeordneten Gleitflächen (6a, 6b, 7a, 7b) haben.

12. Vorrichtung nach einem der vorhergehenden Ansprüche, **dadurch gekennzeichnet, dass** die Wärmeleitkörper (1, 2; 101, 102; 401, 402; 501, 502) einstückig als Strangpressprofil hergestellt sind.

13. Vorrichtung nach Anspruch 12, **dadurch gekennzeichnet, dass** beide Wärmeleitkörper (1, 2) aus dem gleichen Strangpressprofil hergestellt sind.

14. Vorrichtung nach einem der Ansprüche 1 bis 4, **dadurch gekennzeichnet, dass** die zwei horizontal bewegbaren Keile (504a, 504b) gegeneinander weisende Keilspitzen haben und die Keile (504a, 504b) von der Feder (505) gegeneinander gezogen werden.

15. Vorrichtung nach einem der vorhergehenden Ansprüche, **dadurch gekennzeichnet, dass** die beiden Kelle (504a, 504b) durch eine Gummifeder (505) miteinander verbunden sind.

16. Vorrichtung nach Anspruch 15, **dadurch gekennzeichnet, dass** die Keile (504a, 504b) im Bereich Ihrer Keilspitzen quer zur Bewegungsrichtung verlaufende Befestigungsnuten (507a, 507b) aufweisen,
die Gummifeder (505) an zwei gegenüberliegenden Enden Wülste (506a, 506b) hat, welche formschlüssig in den Befestigungsnuten (507a, 507b) sitzen.

17. Vorrichtung nach Anspruch 16, **dadurch gekennzeichnet, dass** die Wärmeleitkörper (501, 502) an ihren zueinander gewandten Seiten Führungsnuten (509a, 509b) haben, welche quer zur Bewegungsrichtung der Wärmeleitkörper (501, 502) und parallel zu den Befestigungsnuten (507a, 507b) der Keile (504a, 504b) verlaufen,
die Gummifeder (505) einen Querschnitt in Form eines Kreuzes mit einer horizontalen und einer vertikalen Linie hat, wobei die Wülste (506a, 506b) an den Enden der horizontalen Linie des Kreuzes angeordnet sind und die Endbereiche der vertikalen Linie des Kreuzes in die Führungsnuten (509a, 509b) der Wärmeleitkörper (501, 502) eingreifen, um eine Führung der Wärmeleitkörper (501, 502) in vertikaler Richtung zu bilden.

18. Vorrichtung nach Anspruch 15, **dadurch gekennzeichnet, dass** die Führungsnuten (509a, 509b) der Wärmeleitkörper (501, 502) einen hinterschnittenen Querschnitt haben und
die Gummifeder (505) an den Enden der vertikalen Linien des Kreuzes wulstartige Verdickungen (508a, 508b) aufweist, welche in den Führungsnuten (509a, 509b) sitzen.

## Claims

1. A heat transferring device with
two massive thermally conductive bodies (1, 2; 101, 102; 401, 402; 501, 502) that are arranged vertically on top of one another and spaced apart by a variable distance,
an elastic spring element, by means of which the two thermally conductive bodies (1, 2; 101, 102; 401, 402; 501, 502) can be pressed apart from one another,
**characterized in that**
at least one spreading element (8, 9, 108, 403, 503) is positioned between the thermally conductive bodies (1, 2; 101, 102; 401, 402; 501, 502) and comprises two horizontally movable wedges (10a, 10b; 12a, 12b; 110a, 110b; 404a, 404b; 504a, 504b), the wedge tips of said two wedges pointing in opposite directions, said spreading element further comprising at least one spring (11, 13, 405, 505) that moves the wedges (10a, 10b; 12a, 12b; 110a, 110b; 404a, 404b; 504a, 504b) along a horizontal axis,
the thermally conductive bodies (1, 2; 101, 102; 401, 402; 501, 502) respectively have at least one pair of sliding surfaces (6a, 6b; 7a, 7b) on their sides that face one another, wherein said sliding surfaces extend parallel to the wedge surfaces (14) and the wedges (10a, 10b; 12a, 12b; 110a, 110b; 404a, 404b; 504a, 504b) slide on these sliding surfaces such that a motion of the wedges in the horizontal direction is converted into a vertical motion of the thermally conductive bodies.

2. The heat transferring device according to claim 1, **characterized in that** the wedges (10a, 10b; 12a, 12b; 110a, 110b; 404a, 404b; 504a, 504b) have a cross section, in which the wedge surfaces (14) lie on the sides of an isosceles triangle.

3. The heat transferring device according to claim 2, **characterized in that** the wedge surfaces (14) extend at an obtuse angle relative to one another.

4. The heat transferring device according to claim 1, **characterized in that** the pairs of sliding surfaces (6a, 6b; 7a, 7b) are respectively arranged on the thermally conductive bodies (1, 2; 101, 102; 401, 402; 501, 502) in a V-shaped manner, wherein the angle between two abutting sliding surfaces (6a, 6b, 7a, 7b) and the angle between the assigned wedge surfaces (14) add up to 180 degrees.

5. The heat transferring device according to claim 1, **characterized in that** the two horizontally movable wedges (10a, 10b; 110a, 110b; 404a, 404b) have wedge tips that point away from one another.

6. The heat transferring device according to claim 1, **characterized in that** the spring (11, 13, 405, 505) is arranged between the wedges (10a, 10b; 12a, 12b; 110a, 110b; 404a, 404b; 504a, 504b).

7. The heat transferring device according to claim 1, **characterized in that** the spring (11, 13, 211, 405) presses the wedges (10a, 10b; 110a, 110b; 404a, 404b) apart from one another

8. The heat transferring device according to claim 1, **characterized in that** the spring (13, 211) consists of a coil spring, the spring axis of which lies in a horizontal plane through the wedge tips.

9. The heat transferring device according to claim 1, **characterized in that**
the thermally conductive bodies (1, 2; 101, 102; 401, 402; 501, 502) are connected to one another by a guiding means such that they essentially can only be moved relative to one another in the vertical direction.

10. The heat transferring device according to claim 9, **characterized in that** the guiding means comprise a stopper means (19, 20; 119a, 119b) that limits the motion in the vertical direction.

11. The heat transferring device according to claim 1, **characterized in that** two spreading elements (8, 9) are arranged horizontally adjacent to one another, and **in that**
the two thermally conductive bodies (1, 2) respectively have two pairs of sliding surfaces (6a, 6b, 7a, 7b) that are arranged in a V-shaped manner.

12. The heat transferring device according to claim 1, **characterized in that**
the thermally conductive bodies (1, 2; 101, 102; 401, 402; 501, 502) are manufactured in one piece in the form of an extruded profile.

13. The heat transferring device according to claim 12, **characterized in that** both thermally conductive bodies (1, 2) are manufactured of the same extruded profile.

14. The heat transferring device according to claim 1, **characterized in that** the two horizontally movable wedges (504a, 504b) have wedge tips that point toward one another and the wedges (504a, 504b) are pulled toward one another by the spring (505).

15. The heat transferring device according to claim 1, **characterized in that** the two wedges (504a, 504b) are connected to one another by a rubber spring (505).

16. The heat transferring device according to claim 15, **characterized in that** the wedges (504a, 504b) feature fastening grooves (507a, 507b) extending transverse to the moving direction in the region of their wedge tips, and **in that**
the rubber spring (505) features beads (506a, 506b) on two opposite ends, wherein said beads are seated in the fastening grooves (507a, 507b) with a positive fit.

17. The heat transferring device according to claim 16, **characterized in that**
the thermally conductive bodies (501, 502) have guide grooves (509a, 509b) extending transverse to the moving direction of the thermally conductive bodies (501, 502) and parallel to the fastening grooves (507a, 507b) of the wedges (504a, 504b) on their sides that face one another, and **in that**
the rubber spring (505) has a cruciform cross section with a horizontal and a vertical line, wherein the beads (506a, 506b) are arranged on the ends of the horizontal line of the cruciform cross section and the end regions of the vertical line of the cruciform cross section engage into the guide grooves (509a, 509b) of the thermally conductive bodies (501; 502) in order to form a guide for the thermally conductive bodies (501, 502) in the vertical direction.

18. The heat transferring device according to claim 15, **characterized in that** the guide grooves (509a, 509b) of the thermally conductive bodies (501, 502) have an undercut cross section, and **in that**
the rubber spring (505) features bead-like enlargements (508a, 508b) that are seated in the guide grooves (509a, 509b) on the ends of the vertical line of its cruciform cross section.

## Revendications

1. Dispositif de transfert de chaleur comportant
deux corps thermoconducteurs massifs (1, 2 ; 101, 102 ; 401, 402 ; 501, 502) superposés verticalement à distance variable ;
un élément élastique permettant d'écarter les deux corps thermoconducteurs (1, 2 ; 101, 102 ; 401, 402 ; 501, 502),
**caractérisé en ce que**
est situé, entre les corps thermoconducteurs (1, 2 ; 101, 102 ; 401, 402 ; 501, 502), au moins un élément d'écartement (8, 9, 108, 403, 503) qui comprend deux coins déplaçables horizontalement (10a, 10b ; 12a, 12b ; 110a, 110b ; 404a, 404b ; 504a, 504b) et comporte des pointes orientées dans des directions opposées, ainsi qu'au moins un ressort (11, 13, 405, 505) qui déplace les coins (10a, 10b; 12a, 12b ; 110a, 110b; 404a, 404b ; 504a, 504b) le long d'un axe horizontal ;
les corps thermoconducteurs (1, 2 ; 101, 102 ; 401, 402 ; 501, 502) ont, sur leurs côtés en regard, respectivement une paire de surfaces coulissantes (6a, 6b ; 7a, 7b) parallèles aux surfaces des coins (14) et sur lesquelles les coins (10a, 10b ; 12a, 12b ; 110a, 110b ; 404a, 404b ; 504a, 504b) coulissent de telle sorte qu'un mouvement des coins dans le sens horizontal est converti en un mouvement vertical des corps thermoconducteurs.

2. Dispositif selon la revendication 1, **caractérisé en ce que** les coins (10a, 10b ; 12a, 12b ; 110a, 110b ; 404a, 404b ; 504a, 504b) ont une section transversale telle que les surfaces des coins (14) se trouvent sur les côtés d'un triangle isocèle.

3. Dispositif selon la revendication 2, **caractérisé en ce que** les surfaces des coins (14) forment entre elles un angle obtus.

4. Dispositif selon l'une des revendications précédentes, **caractérisé en ce que** les paires de surfaces coulissantes (6a, 6b ; 7a, 7b) sont agencées respectivement en V sur les corps thermoconducteurs (1, 2 ; 101, 102 ; 404, 402; 501, 502), l'angle formé par deux surfaces coulissantes convergentes (6a, 6b, 7a, 7b) et l'angle formé par les surfaces des coins associées (14) se complétant pour obtenir 180 degrés.

5. Dispositif selon l'une des revendications, **caractérisé en ce que** les deux coins déplaçables horizontalement (10a, 10b ; 110a, 110b ; 404a, 404b) comportent des pointes allant s'écartant.

6. Dispositif selon l'une des revendications précédentes, **caractérisé en ce que** le ressort (11, 13, 405, 505) est agencé entre les coins (10a, 10b ; 12a, 12b ; 110a, 110b ; 404a, 404b ; 504a, 504b).

7. Dispositif selon l'une des revendications précédentes, **caractérisé en ce que** le ressort (11, 13, 211, 405) écarte les coins (10a, 10b ; 110a, 110b ; 404a, 404b).

8. Dispositif selon l'une des revendications précédentes, **caractérisé en ce que** le ressort (13, 211) est un ressort hélicoïdal dont l'axe se trouve dans un plan horizontal passant par les pointes des coins.

9. Dispositif selon l'une des revendications précédentes, **caractérisé en ce que** les corps thermoconducteurs (1, 2 ; 101, 102 ; 401, 402 ; 501, 502) sont reliés entre eux par un guidage de telle sorte qu'ils sont mobiles l'un par rapport à l'autre sensiblement en direction verticale seulement.

10. Dispositif selon la revendication 9, **caractérisé en ce que** le guidage comporte une butée (19, 20 ; 119a, 119b) qui limite le mouvement dans le sens vertical.

11. Dispositif selon l'une des revendications précédentes, **caractérisé en ce que**
deux éléments d'écartement (8, 9) sont agencés horizontalement l'un à côté de l'autre ;
les deux corps thermoconducteurs (1, 2) comportent respectivement deux paires de surfaces coulissantes (6a, 6b, 7a, 7b) agencées en V.

12. Dispositif selon l'une des revendications précédentes, **caractérisé en ce que** les corps thermoconducteurs (1, 2 ; 101, 102 ; 401, 402 ; 501, 502) sont réalisés d'une seule pièce en tant que profilé extrudé.

13. Dispositif selon la revendication 12, **caractérisé en ce que** les deux corps thermoconducteurs (1, 2) sont réalisés à partir du même profilé extrudé.

14. Dispositif selon l'une des revendications 1 à 4, **caractérisé en ce que** les deux coins (504a, 504b) déplaçables horizontalement comportent des pointes qui se font face et **en ce que** les coins (504a, 504b) sont tirés les uns contre les autres par le ressort (505).

15. Dispositif selon l'une des revendications précédentes. **caractérisé en ce que** les deux coins (504a, 504b) sont reliés entre eux par un ressort en caoutchouc (505).

16. Dispositif selon la revendication 15, **caractérisé en ce que** les coins (504a, 504b) comportent, dans la zone de leurs pointes, des rainures de fixation (507a, 507b) transversales par rapport à la direction du mouvement ;
le ressort en caoutchouc (505) comporte, en deux extrémités opposées, des bourrelets (506a, 506b) agencés avec complémentarité de forme dans les rainures de fixation (507a, 507b).

17. Dispositif selon la revendication 16, **caractérisé en ce que**
les corps thermoconducteurs (501, 502) présentent, sur les faces en regard, des rainures de guidage (509a, 509b) transversales par rapport au sens du mouvement des corps thermoconducteurs (501, 502) et parallèles aux rainures de fixation (507a, 507b) des coins (504a, 504b) ;
le ressort en caoutchouc (505) présente une section transversale en forme de croix avec une ligne horizontale et une ligne verticale, les bourrelets (506a, 506b) étant agencés aux extrémités de la ligne horizontale de la croix et les parties terminales de la ligne verticale de la croix s'engageant dans les rainures de guidage (509a, 509b) des corps thermoconducteurs (501, 502) afin de former un guidage des corps thermoconducteurs (501, 502) dans le sens vertical.

18. Dispositif selon la revendication 15, **caractérisé en ce que**
les rainures de guidage (509a, 509b) des corps thermoconducteurs (501, 502) ont une section transversale rentrante et
le ressort en caoutchouc (505) comporte, aux extrémités des lignes verticales de la croix, des épaississements en forme de bourrelet (508a, 508b) qui se trouvent dans les rainures de guidage (509a, 509b).
